Europäisches Patentamt

European Patent Office

Office européen des brevets

(19)

(11) Numéro de publication: **0 063 520**
**B1**

(12) **FASCICULE DE BREVET EUROPEEN**

(45) Date de publication du fascicule du brevet: 06.02.85

(21) Numéro de dépôt: **82400658.9**

(22) Date de dépôt: **09.04.82**

(51) Int. Cl.⁴: **G 01 R 31/00,** G 01 R 27/26

(54) Commutateur de mesure électrique d'impédances réactives, et pont de mesure utilisant un tel commutateur.

(30) Priorité: **21.04.81 FR 8107913**

(43) Date de publication de la demande: **27.10.82 Bulletin 82/43**

(45) Mention de la délivrance du brevet: **06.02.85 Bulletin 85/6**

(84) Etats contractants désignés: **DE GB NL**

(56) Documents cités:
**CH - A - 324 459**
**GB - A - 907 011**

**SOVIET INSTRUMENTATION AND CONTROL JOURNAL "(a cover to cover translation of the Russian original journal: Pribory i sistemy upralenlya)" no. 3, mars 1971, OXFORD (GB) A.A. RUKHLENKOV et al. "The MTsE-9A digital measuring instrument", pages 58-61**

(73) Titulaire: **L.C.C.-C.I.C.E. - COMPAGNIE EUROPEENNE DE COMPOSANTS ELECTRONIQUES, 50, rue Jean-Pierre Timbaud B.P. 301, F-92402 Courbevoie (FR)**

(72) Inventeur: **Colin, Gérard, THOMSON-CSF SCPI 173, bld Haussmann, F-75360 Paris Cedex 08 (FR)**
Inventeur: **Reamot, Hervé, THOMSON-CSF SCPI 173, bld Haussmann, F-75360 Paris Cedex 08 (FR)**

(74) Mandataire: **Jacquard, Philippe et al, THOMSON-CSF SCPI 173, Bld Haussmann, F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un commutateur pour la mesure électrique d'impédances réactives, comportant n branches en parallèle avec $n \geqslant 1$, chaque branche étant constituée d'une impédance réactive à mesurer et d'un interrupteur, l'ensemble des interrupteurs étant soumis à un signal de commande qui connecte successivement chaque impédance réactive en parallèle sur un pont de mesure.

La présente invention concerne également un pont de mesure utilisant un tel commutateur.

Ce type de commutateur est généralement commandé par un signal électrique. Il est alors désigné par le nom de commutateur électronique. Un commutateur électronique consiste à mesurer n composants dans un temps minimal sans transfert mécanique. Généralement, ce type de commutateur est utilisé pour la mesure d'impédances réactives. Par impédance réactive, on entend un circuit formé soit par une ou plusieurs capacités, soit par une ou plusieurs inductances, soit par une combinaison des deux, ledit circuit pouvant comporter des éléments résistifs. Cette mesure s'effectue à l'aide d'un pont de mesure du type Wien ou Nernst. La mesure s'effectue à différentes fréquences selon le type d'impédance à mesurer. Pour plus de détails, on se reportera par exemple à l'article intitulé «Mesure sur condensateurs» par C. Leclercq, publié par le laboratoire central des industries électriques.

Dans chaque branche, l'interrupteur possède deux positions: la position fermée, qui relie électriquement la première armature du condensateur à la première extrémité du pont de mesure, la deuxième armature du condensateur étant reliée électriquement à la deuxième extrémité du pont de mesure, et la position ouverte, dans laquelle le contact électrique entre la première armature et la première extrémité du pont est ouvert. La commutation d'une position à l'autre est provoquée par un signal électrique de fréquence de l'ordre de 5 Hz, qui ferme successivement chaque branche de sorte qu'un seul interrupteur est fermé et les autres ouverts.

Le commutateur idéal a les caractéristiques suivantes: une résistance nulle à la fermeture, infinie à l'ouverture et des temps de commutation infiniment courts. On utilise habituellement pour interrupteurs des relais REED inverseurs, de capacité entre contacts inférieure à 1,5 pF, qui correspondent à ces caractéristiques, et pour pont de mesure, un pont de mesure automatique RLC, bien connu de l'homme de l'art.

Toutefois, les capacités entre les contacts de l'interrupteur introduisent des capacités parasites perturbant la mesure. Cet inconvénient est général à tous les interrupteurs et ne s'applique pas spécialement aux relais REED inverseurs. En effet, lorsque l'interrupteur est ouvert, une capacité parasite entre les deux contacts de l'interrupteur s'établit en série avec la capacité à mesurer de la branche considérée. La capacité du commutateur prend donc la valeur équivalente:

$$C \text{ équivalent} = \frac{C_x \cdot C_p}{C_x + C_p} \times n$$

dans lequel $C_x$ est la capacité à mesurer, $C_p$ est la capacité parasite entre contacts et n est le nombre de branches. La capacité équivalente du commutateur ainsi introduite peut prendre des valeurs comparables aux capacités que l'on veut mesurer. La capacité équivalente varie en fonction du nombre et de la valeur des composants à mesurer. De plus, la valeur de la capacité équivalente varie à chaque commutation, chacune des branches n'ayant pas exactement les mêmes caractéristiques. De plus, toutes les branches du commutateur ne sont pas nécessairement utilisées au cours d'une mesure. Dans ce cas, la capacité parasite de chaque branche non utilisée n'entre pas en ligne de compte pour la mesure. D'où l'impossibilité de mesurer des capacités de faible valeur avec précision sans avoir recours à une correction.

Il a déjà été proposé d'utiliser une correction consistant en un équilibrage du pont de mesure avant chaque cycle de mesure. Toutefois, ce moyen perd l'avantage de la vitesse d'une commutation électronique. La remise à zéro d'un pont demande du temps durant lequel le commutateur pourrait effectuer plusieurs mesures.

Il a été également proposé d'utiliser un calculateur pour soustraire automatiquement la capacité parasite. Toutefois, ce calculateur est d'un maniement peu aisé, encombrant et augmente considérablement le prix de revient du commutateur. De plus, dans le cas où toutes les branches ne sont pas utilisées, il est nécessaire de l'indiquer au calculateur afin qu'il effectue la correction adéquate.

Par conséquent, il n'existe pas à l'heure actuelle de commutateur de prix de revient faible et conservant la vitesse de commutation électronique.

Le commutateur selon l'invention ne possède pas les inconvénients des systèmes décrits ci-dessus et permet une mesure avec des capacités parasites constantes quel que soit le nombre de branches utilisées du commutateur. Dans ce but, il est caractérisé comme décrit dans la partie caractérisante de la revendication 1. Chaque interrupteur possède ainsi trois contacts: un contact relié électriquement à la première extrémité du pont de mesure que l'on nomme contact C ou contact travail, un contact relié électriquement à la première armature du condensateur que l'on nomme contact B, un contact relié électriquement à la deuxième extrémité du pont de mesure et à la deuxième armature du condensateur que l'on nomme contact A ou contact repos. Dans le cas de la deuxième position, la capacité à mesurer étant en court-circuit, c'est-à-dire que la première armature est reliée électriquement à la seconde armature, ladite capacité n'est pas prise en compte dans la mesure effectuée par le pont de mesure. Dans le cas de la première position envisagée, la capacité à mesurer est branchée sur le pont de mesure.

En fonctionnement, un seul interrupteur occupe la première position, tous les autres ayant la deuxième position. La mesure de capacité s'effectue dans la branche où l'interrupteur a la première position: la capacité à mesurer de cette branche sera nommée, dans toute la suite de l'exposé, capacité mesurée. Dans le cas de la deuxième position, une capacité parasite s'établira entre le contact C et le contact B. Cette capacité sera ainsi en parallèle sur la capacité mesurée. Dans le cas de la première position envisagée, une capacité parasite s'établira entre le contact A et le contact B. Cette capacité sera, également, en parallèle sur la capacité mesurée. Lors de la commutation, la capacité parasite d'une position disparaît mais elle est compensée par la capacité parasite de l'autre position dont la valeur est sensiblement identique. La capacité équivalente du commutateur reste donc constante quels que soient la valeur et le nombre des capacités à mesurer. Chaque commutateur a sa propre capacité parasite dont la valeur est fonction du nombre de branches composant ce dernier:

$$C \text{ équivalent} = C_p \times n$$

dans lequel $C_p$ est la capacité parasite, n est le nombre de branches du commutateur. L'équilibre du pont se fait, donc, avant l'utilisation du commutateur pour plusieurs séries de mesure, sur cette capacité parasite équivalente fixe.

Le commutateur selon l'invention présente l'avantage d'être peu encombrant puisqu'il peut être réalisé sur circuit imprimé. Il est d'un maniement simple. De plus, il peut être utilisé sans réglage préalable pour plusieurs séries de mesure avec des capacités de valeurs différentes. Enfin, il est possible de ne pas utiliser toutes les branches sans aucune modification de réglage.

On utilisera, de préférence, comme interrupteurs dans la présente invention des relais REED inverseurs, de capacité entre contacts inférieure à 1,5 pF.

Selon un mode préférentiel de réalisation, le commutateur selon l'invention est caractérisé en ce que des condensateurs ajustables sont disposés en parallèle sur l'une au moins des positions de l'interrupteur.

En effet, les jonctions entre les différents éléments peuvent introduire des capacités parasites de moindre importance que les capacités parasites de contact. En particulier, les jonctions entre les condensateurs à mesurer et le commutateur introduisent des capacités parasites de jonction. Ces capacités parasites de jonction sont de faible valeur, typiquement quelques centièmes ou quelques dixièmes de picofarads. Elles peuvent perturber la mesure pour des capacités à mesurer dont l'ordre de grandeur est de quelques dizaines de picofarads. Ces capacités parasites de jonction sont donc en série avec la capacité à mesurer et chaque branche du commutateur a sa propre capacité parasite de jonction. La mise en place des condensateurs ajustables entre les contacts A,B et B,C permet d'égaliser chacune des capacités parasites de jonction à une valeur fixe. L'ajustage se fait pour plusieurs séries de mesure.

La présente invention sera mieux comprise à l'aide de la description suivante donnée à titre non limitatif conjointement aux figures qui représentent:

— la fig. 1, le commutateur selon l'art antérieur,
— la fig. 2, le commutateur selon la présente invention.

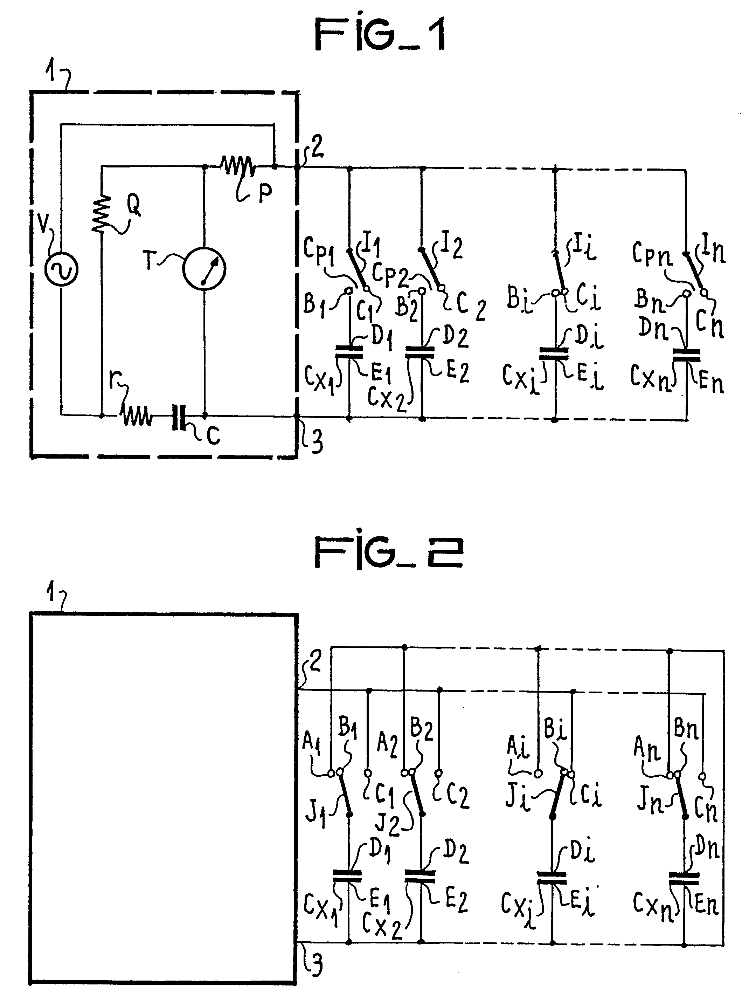

Sur la fig. 1, le pont de mesure 1 est relié en 2 aux contacts $C_1$, $C_2$, ..., $C_n$ des interrupteurs $I_1$, ..., $I_n$. Les contacts $B_1$, $B_2$, ..., $B_n$ sont connectés respectivement aux premières armatures $D_1$, $D_2$, ..., $D_n$ des condensateurs $C_{x_1}$, ..., $C_{x_n}$, dont les secondes armatures $E_1$, $E_2$, ..., $E_n$ sont reliées à la deuxième extrémité 3 du pont de mesure 1. La branche comportant l'interrupteur $I_i$ en série avec la capacité $C_{x_i}$ est le circuit fermé où s'effectue la mesure. Dans toutes les autres branches, l'interrupteur est dans la position ouverte. Les éléments du pont de mesure 1 sont schématisés sous la forme d'un pont de Wien comportant les éléments:

— P qui est une résistance d'équilibrage du pont de mesure,
— Q qui est une résistance d'équilibrage du pont de mesure,
— r qui est une résistance ajustable,
— C qui est une capacité ajustable,
— T qui est un galvanomètre,
— V qui est un générateur alternatif de courant.

En fonctionnement, lorsque la mesure de la capacité $C_{x_i}$ est terminée, l'interrupteur de la branche où s'effectuait cette mesure s'ouvre et l'interrupteur de la branche suivante se ferme afin d'effectuer la mesure de la capacité à mesurer de cette dernière branche. La commutation est provoquée par un signal électrique de fréquence de l'ordre de 5 Hz. Ce signal ferme successivement chaque branche de sorte qu'un seul interrupteur soit fermé et les autres soient ouverts.

Dans toutes les branches où l'interrupteur est ouvert, une capacité parasite s'établit entre les contacts du type $B_1$, ..., $B_{i-1}$, $B_{i+1}$, ..., $B_n$ et respectivement les contacts du type $C_1$, ..., $C_{i-1}$, $C_{i+1}$, ..., $C_n$. Ces capacités parasites sont représentées par $C_{P_1}$, ..., $C_{P_{i-1}}$, $C_{P_{i+1}}$, ..., $C_{P_n}$. Dans chacune des branches ouvertes s'établit donc une capacité parasite en série avec la capacité à mesurer de la branche considérée. Le commutateur se résumera alors du point de vue capacitif à deux capacités en parallèle: d'une part, la capacité à mesurer de la branche fermée et, d'autre part, la capacité équivalente formée par la somme des capacités des branches ouvertes, chacune des capacités des branches ouvertes étant constituée de la capacité parasite de ladite branche en série avec sa capacité à mesurer. Cette capacité équivalente du commutateur peut prendre des valeurs comparables aux capacités que l'on veut mesurer. La capacité équivalente (voir formule ci-dessus) varie à chaque série de mesure et à chaque commutation, ce qui pose des problèmes de rééquilibrage du pont de mesure. Ces problèmes ne peuvent être résolus sans une correction longue et malaisée. Pratiquement, la capacité parasite équivalente est de l'ordre de 20 pF. Si l'on désire une précision de 2%, on ne peut mesurer des capacités inférieures à 1000 pF.

Sur la fig. 2 est représenté le commutateur selon l'invention. Sur cette figure, les mêmes éléments que ceux de la fig. 1 portent les mêmes références. Les interrupteurs sont représentés en $J_1$, ..., $J_n$. Les points de contact $A_1$, ..., $A_n$ des interrupteurs $J_1$, ..., $J_n$ sont reliés électriquement à la deuxième armature des condensateurs respectifs $C_{x_1}$, ..., $C_{x_n}$ et à la deuxième extrémité 3 du pont de mesure 1. Les points de contact $B_1$, ..., $B_n$ des interrupteurs respectivement $J_1$, ..., $J_n$ sont reliés électriquement à la première armature des condensateurs respectifs $C_{x_1}$, ..., $C_{x_n}$. Les points de contact $C_1$, ..., $C_n$ des interrupteurs respectivement $J_1$, ..., $J_n$ sont reliés électriquement à la première extrémité 2 du pont de mesure 1. Chaque interrupteur $J_1$, ..., $J_n$ peut donc prendre deux positions. Dans la première position, les points de contact du type $B_1$, ..., $B_n$ sont en liaison électrique avec les points de contact du type respectivement $C_1$, ..., $C_n$. Dans la seconde position, les points de contact du type $B_1$, ..., $B_n$ sont en liaison électrique avec les points de contact du type respectivement $A_1$, ..., $A_n$.

En fonctionnement, la première position est la position de mesure de la capacité à mesurer correspondante tandis que la seconde position est une position d'attente de la mesure de la capacité à mesurer correspondante qui est en court-circuit, c'est-à-dire que sa première armature est reliée à sa seconde armature. Ladite capacité n'entre alors pas dans la mesure effectuée par le pont de mesure 1. Lorsque la mesure d'une capacité à mesurer est terminée, l'interrupteur correspondant passe de la position 1 à la position 2. L'interrupteur de la branche suivante passe alors de la position 2 à la position 1 de façon à effectuer la mesure de la capacité de la branche suivante. La commutation est provoquée par un signal électrique de fréquence de l'ordre de 5 Hz. Ce signal bascule successivement les interrupteurs de la position 1 à la position 2 de sorte qu'un seul interrupteur soit dans la position de mesure, les autres étant dans une position d'attente. Sur la fig. 2, les interrupteurs $J_1$, ..., $J_{i-1}$, $J_{i+1}$, ..., $J_n$ sont dans la position 2 alors que l'interrupteur $J_i$ est dans la position 1.

Dans le cas de la position 2, la capacité parasite s'établit donc, entre les points de contact du type $B_1$, ..., $B_n$ et les points de contact du type respectivement $C_1$, ..., $C_n$. Cette capacité parasite est en parallèle sur la capacité à mesurer correspondante ainsi, d'ailleurs, que sur les capacités parasites des autres branches. Dans le cas de la position 1, la capacité parasite s'établit entre les points de contact du type $B_1$, ..., $B_n$ et les points de contact du type respectivement $A_1$, ..., $A_n$. Cette capacité parasite est en parallèle sur la capacité à mesurer correspondante ainsi que sur les capacités parasites des autres branches. Pour un même interrupteur, les capacités parasites existant dans les deux positions sont de valeur sensiblement égale.

La capacité parasite équivalente du commutateur est indépendante, alors, des valeurs des capacités à mesurer et indépendante du nombre de capacités à mesurer. Elle ne dépend que des caractéristiques du commutateur: le nombre de branches que celui-ci possède et les valeurs des capacités parasites de contact de chacun des interrupteurs (voir la formule ci-dessus).

L'équilibre du pont de mesure 1 se fait, donc, avant l'utilisation du commutateur pour plusieurs séries de mesure sur la capacité équivalente fixe. On peut mesurer avec précision des capacités de l'ordre de quelques picofarads. Pratiquement, l'invention permet de mesurer avec une précision de 2% des capacités de l'ordre de 10 pF.

## Revendications

1. Commutateur pour la mesure d'impédance réactive ($C_{x_1}$, ..., $C_{x_n}$) comportant n branches en parallèle avec n ⩾ 1, chaque branche étant constituée d'une impédance réactive à mesurer ($C_{x_1}$, ..., $C_{x_n}$) et d'un interrupteur ($J_1$, ..., $J_n$), l'ensemble des interrupteurs étant soumis à un signal de commande qui connecte successivement chaque impédance réactive ($C_{x_1}$, ..., $C_{x_n}$) en parallèle sur un pont de mesure (1) comportant une première (2) et une seconde (3) borne, caractérisé en ce que chaque interrupteur ($J_1$, ..., $J_n$) peut prendre deux positions, l'une des positions ($B_1C_1$, ..., $B_nC_n$) reliant électriquement la première extrémité ($D_1$, ..., $D_n$) de l'impédance réactive à mesurer ($C_{x_1}$, ..., $C_{x_n}$) à la première borne (2) du pont de mesure (1), l'autre position ($B_1A_1$, ..., $B_nA_n$) reliant électriquement la première extrémité ($D_1$, ..., $D_n$) de l'impédance réactive ($C_{x_1}$, ..., $C_{x_n}$) à la seconde extrémité de cette impédance ($E_1$, ... $E_n$), ladite seconde extrémité étant connectée à la seconde borne (3) du pont de mesure (1).

2. Commutateur selon la revendication 1, caractérisé en ce que l'impédance réactive est une capacité.

3. Commutateur selon l'une des revendications 1 ou 2, caractérisé en ce que les interrupteurs sont des relais REED inverseurs.

4. Commutateur selon l'une des revendications 1 à 3, caractérisé en ce que des condensateurs ajustables sont disposés en parallèle sur l'une au moins des positions de l'interrupteur.

5. Commutateur selon l'une des revendications 1 à 4, caractérisé en ce que n est compris entre 10 et 40.

6. Pont de mesure de capacité utilisant un commutateur selon l'une des revendications précédentes.

## Claims

1. Switch for the measurement of the reactive impedance ($C_{x_1}$, ..., $C_{x_n}$) comprising n parallel branches with n ⩾ 1, each branch being made up of a reactive impedance to be measured ($C_{x_1}$, ..., $C_{x_n}$) and an interrupter ($J_1$, ..., $J_n$), all of these interrupters being subjected to a control signal connecting successively each reactive impedance ($C_{x_1}$, ..., $C_{x_n}$) in parallel to a measuring bridge (1) comprising a first (2) and a second (3) terminal, characterized in that each interrupter ($J_1$, ..., $J_n$) can take two positions, one of the positions ($B_1C_1$, ..., $B_nC_n$) electrically connecting the first end ($D_1$, ..., $D_n$) of the reactive impedance to be measured ($C_{x_1}$, ..., $C_{x_n}$) to the first terminal (2) of the measurement bridge (1), the other position ($B_1A_1$, ..., $B_nA_n$) electrically connecting the first end ($D_1$, ..., $D_n$) of the reactive impedance ($C_{x_1}$, ..., $C_{x_n}$) to the second end of this impedance ($E_1$, ..., $E_n$), said second end being connected to the second terminal (3) of the measurement bridge (1).

2. Switch according to Claim 1, characterized in that the reactive impedance is a capacity.

3. Switch according to Claim 1 or 2, characterized in that the interrupters are REED change-over relays.

4. Switch according to any of Claims 1 to 3, characterized in that adjustable capacitors are arranged in parallel in at least one of the positions of the interrupter.

5. Switch according to any of Claims 1 to 4, characterized in that n is comprised between 10 and 40.

6. Capacity measurement bridge using a switch according to any of the preceding claims.


**Patentansprüche**

1. Schalter zur Messung der reaktiven Impedanz ($C_{x_1}$, ..., $C_{x_n}$), mit n parallelliegenden Zweigen, wobei $n \geqslant 1$, wobei jeder Zweig aus einer zu messenden reaktiven Impedanz ($C_{x_1}$, ..., $C_{x_n}$) und einem Unterbrecher ($J_1$, ..., $J_n$) gebildet ist, während die Gesamtheit der Unterbrecher einem Steuersignal unterstellt ist, welches nacheinander jede reaktive Impedanz ($C_{x_1}$, ..., $C_{x_n}$) parallel auf eine Messbrücke (1) schaltet, die einen ersten (2) sowie einen zweiten (3) Anschluss aufweist, dadurch gekennzeichnet, dass jeder Unterbrecher ($J_1$, ..., $J_n$) zwei Stellungen einnehmen kann, wobei eine der Stellungen ($B_1C_1$, ..., $B_nC_n$) das erste Ende ($D_1$, ..., $D_n$) der zu messenden reaktiven Impedanz ($C_{x_1}$, ..., $C_{x_n}$) elektrisch mit dem ersten Anschluss (2) der Messbrücke (1) verbindet, während die andere Stellung ($B_1A_1$, ..., $B_nA_n$) das erste Ende ($D_1$, ..., $D_n$) der reaktiven Impedanz ($C_{x_1}$, ..., $C_{x_n}$) mit dem zweiten Ende dieser Impedanz ($E_1$, ..., $E_n$) elektrisch verbindet, wobei das genannte zweite Ende mit dem zweiten Anschluss (3) der Messbrücke (1) verbunden ist.

2. Schalter nach Anspruch 1, dadurch gekennzeichnet, dass die reaktive Impedanz eine Kapazität ist.

3. Schalter nach einem der Ansprüche 1 oder 2, dadurch gekennzeichnet, dass die Unterbrecher REED-Umschaltrelais sind.

4. Schalter nach einem der Ansprüche 1 bis 3, dadurch gekennzeichnet, dass einstellbare Kondensatoren in wenigstens einer der Stellungen des Unterbrechers parallelgeschaltet sind.

5. Schalter nach einem der Ansprüche 1 bis 4, dadurch gekennzeichnet, dass n zwischen 10 und 40 beträgt.

6. Kapazitätsmessbrücke, bei der ein Schalter nach einem der vorstehenden Ansprüche Verwendung findet.

0 063 520

FIG_1

FIG_2

7